# EUROPEAN PATENT SPECIFICATION

(11) **EP 2 703 116 B1**
(45) Date of publication and mention of the grant of the patent: **22.03.2017**
(21) Application number: 12006236.9
(22) Date of filing: 04.09.2012
(51) Int. Cl.: B23K 35/30, C22C 5/06

(54) **Method for manufacturing a silver alloy wire for bonding applications**
Verfahren zur Herstellung eines Silberlegierungsdrahtes für Bindungsanwendungen
Procédé de fabrication d'un fil d'alliage d'argent pour des applications de liaison

(43) Date of publication of application: 05.03.2014
(73) Proprietor: Heraeus Deutschland GmbH & Co. KG, 63450 Hanau (DE)
(72) Inventor: Ryu, Jae-Sung, Sonsa-gu, Bucheon-si, Gyeonggi-do (KP); Chung, Eun-Kyun, Nojurksan-Ro 43, Nam-Ku, Inchon (KP); Tark, Yong-Deok, Namdong-gu, Incheon (KP)
(74) Representative: Heraeus IP

(56) References cited:
- WO-A1-2012/108082
- JP-A- 2012 099 577
- TW-A- 201 204 843
- US-A1- 2011 011 619
- US-A1- 2012 093 681

## Description

The invention is related to a method for manufacturing a bonding wire, comprising:
a core with a surface, wherein the core comprises silver as a main component and at least one member selected from the group consisting of gold, palladium, platinum, rhodium, ruthenium, nickel, copper and iridium.

The invention further relates to a bonding wire made by the method.

Bonding wires are used in the manufacture of semiconductor devices for electrically interconnecting an integrated circuit and a printed circuit board during semiconductor device fabrication. Further, bonding wires are used in power electronic applications to electrically connect transistors, diodes and the like with pads or pins of the housing. While bonding wires were made from gold in the beginning, nowadays less expensive materials are used such as silver. While silver wire provides very good electric and thermal conductivity, bonding of silver wire has its challenges.

The present invention, the term bonding wire comprises bonding wires with circular cross-section.

Some recent developments were directed to bonding wires having a core material based on silver as a main component due to its lower price compared with gold. Nevertheless, there is an ongoing need for further improving bonding wire technology with regard to the bonding wire itself and the bonding processes.

US2012/0263624A1 discloses an Ag-Au-Pd ternary alloy bonding wire for semiconductor devices made from silver (Ag) having a purity of 99.99 mass % or higher, gold (Au) having a purity of 99. 999 mass % or higher and palladium (Pd) having a purity of 99.99 mass % or higher, said wire being composed of 4-10 mass % of said gold (Au), 2-5 mass % of said palladium (Pd), 15-70 mass ppm of oxidizing non-noble metallic elements and residual % of said silver (Ag), and said wire being thermally annealed at least once before being continuously drawn through dies, and said wire being thermally tempered after being continuously drawn through said dies, and said wire being applicable for ball bonding in a nitrogen atmosphere.

Accordingly, it is an object of the invention to provide a method for manufacturing improved bonding wires.

Thus, it is another object of the invention to provide a method for manufacturing a bonding wire, which has good processing properties and which has no specific needs when interconnecting, thus saving costs.

It is also an object of the invention to provide a method for manufacturing a bonding wire which has excellent electrical and thermal conductivity.

It is a further object of the invention to provide a method for manufacturing a bonding wire which exhibits an improved reliability.

It is a further object of the invention to provide a method for manufacturing a bonding wire which exhibits excellent bondability.

It is another object of the invention to provide a method for manufacturing a bonding wire which shows an improved bondability with respect to a second bonding or wedge bonding.

It is yet another object of the invention to provide a method for manufacturing a bonding wire having a high stich pull value as well as a low standard deviation of the stitch pull value.

It is yet another object of the invention to provide a method for manufacturing a bonding wire having a high ball shear value as well as a low standard deviation of the ball shear value.

It is yet a further object of the invention to provide a method for manufacturing a bonding wire having a low electrical resistivity.

It is another object to provide a method for manufacturing a bonding wire, the method basically showing no increase in manufacturing costs compared with known methods.

Surprisingly, wires made by the manufacturing method of the present invention have been found to solve at least one of the objects mentioned above. Further, a process for manufacturing these wires has been found which overcomes at least one of the challenges of manufacturing wires. Further, systems comprising the wires made by the manufacturing method of the invention were found to be more reliable at the interface between the wire made by the manufacturing method according to the invention and other electrical elements.

A contribution to the solution of at least one of the above objects is provided by the subject matters of the category-forming claims, whereby the dependent subclaims of the category-forming independent claims representing preferred aspects of the invention, the subject matter of which likewise makes a contribution to solving at least one of the objects mentioned above.

A first aspect of the invention is a method for manufacturing a bonding wire having a diameter in the range of 8 to 80 µm and comprising a core with a surface, wherein the core comprises silver as a main component and at least one member selected from the group consisting of gold, palladium and platinum, characterized in that the bonding wire has at least one of the following combinations of properties:
i) an average size of crystal grains of the core is between 0.8 µm and 3 µm,
ii) the amount of crystal grains having an orientation in <001> direction in the cross section of the wire is in the range of 10 - 20 %, and
iii) the total amount of crystal grains having an orientation in <001 > direction and of crystal grains having an orientation in <111> direction in the cross section of the wire is in the range of 15 - 40 %,
or
i) an average size of crystal grains of the core is between 0.8 µm and 3 µm,
ii) the amount of crystal grains having an orientation in <111> direction in the cross section of the wire is in the range of 5 - 15 %, and
iii) the total amount of crystal grains having an orientation in <001 > direction and of crystal grains having an orientation in <111> direction in the cross section of the wire is in the range of 15 - 40 %,
or
i) an average size of crystal grains of the core is between 0.8 µm and 3 µm,
ii) the amount of crystal grains having an orientation in <001> direction in the cross section of the wire is in the range of 10 - 20 %, and
iii) the amount of crystal grains having an orientation in <111> direction in the cross section of the wire is in the range of 5 - 15 %,
wherein the method comprises the steps of
a. providing a wire core precursor,
b. pulling the precursor until a final diameter of the wire core is reached,
c. annealing the pulled wire at a minimum annealing temperature for a minimum annealing time,
d. intermediate annealing of the wire core precursor at an intermediate annealing temperature in the range of 450 °C and 550 °C and for an intermediate annealing time in the range of 30 minutes and 120 minutes prior to step b, and
e. cooling the wire after intermediate annealing from at least the intermediate annealing temperature down to room temperature, wherein the duration of the cooling step is at least half of the duration of the exposure time of the intermediate annealing or the same as the duration of the intermediate annealing step,
wherein the core precursor has a diameter of at least 0,5 mm when exposed to the intermediate annealing step,
wherein the diameter of the core during intermediate annealing does not exceed 10 mm, and
wherein the diameter reduction ratio obtained by forming steps between the final wire diameter and the intermediately annealed core is chosen in a range of 0.1 to 0.002.

All contents or shares of components are presently given as shares in weight. In particular, component shares given in percent are meant to be weight-%, and component shares given in ppm (parts per million) are meant to be weight-ppm. For percentage values concerning crystal grains of a specific size and/or orientation, the values are shares of a total number of particles.

For the determination of grain sizes and/or grain orientations, wire samples have been prepared, measured and evaluated by use of electron microscopy, in particular by EBSD (= Electron Backscatter Diffraction). Concerning the exact definition of the claimed features of the invention, reference is made to the description of an exemplary embodiment of the invention hereinafter.

Preferably, the wire made by the manufacturing method according to the invention has no coating layer covering the surface of the core. This provides for a simple and cost saving manufacturing of the wire. This does not exclude that for specific applications, there might be a coating layer provided on the surface of the core of a wire made by the manufacturing method of the invention.

A component is a "main component" if the share of this component exceeds all further components of a referenced material. Preferably, a main component comprises at least 50% of the total weight of the material.

In a preferred embodiment, the core comprises silver as a main component and at least one member is selected from the group consisting of gold, palladium and platinum.

In a preferred detailed embodiment, the core comprises 80 - 95 wt.% silver, 5 - 12 wt.% gold, 1.5 - 5 wt.% palladium and up to 0.01 wt.% unavoidable impurities. In this embodiment, The amount of gold content is more preferably in the range of 5% to 12% and most preferably in the range of 6% to 10%. The amount of palladium is more preferably in the range of 2% to 5% and most preferably in the range of 2% to 4%.

In an alternative embodiment, the core comprises 90 - 99.7 wt.% silver, 0.3 - 10 wt.% gold and up to 0.01 wt.% unavoidable impurities.

In another alternative embodiment, the core comprises 90 - 99.7 wt.% silver, 0.3 - 10 wt.% palladium and up to 0.01 wt.% unavoidable impurities.

In yet another alternative embodiment, the core comprises 80 - 99 wt.% silver, 0 - 10 wt.% gold, 1 - 20 wt.% palladium and up to 0.01 wt.% unavoidable impurities.

In specifically preferred embodiments of the invention, the average size of crystal grains of the core is between 1.0 µm and 1.6 µm. Such size of the crystal grains is particularly homogenous and contributes to a good reproducibility of the wire properties.

In a most advantageous embodiment, a standard deviation of the size of the crystal grains is between 0 µm and 0.5 µm. More preferably, the standard deviation of the crystal grain size is between 0 µm and 0.4 µm, or even between 0 µm and 0.25 µm. It surprisingly turned out that the quality and reproducibility of the wire properties are significantly enhanced if the crystal grains are particularly homogenous in size.

Generally, the grain size and further structure of the grains like their orientation can be adjusted by appropriate selection of known manufacturing parameters. These are annealing parameters like annealing temperature and exposure time as well as other parameters like the number of pulling steps, a respective diameter reduction and further more.

The wire has been exposed to an intermediate annealing step prior to a final pulling step of the wire. Intermediate annealing means that such annealing is performed before further steps or measures influencing the microstructure of the wire are taken. Such step is, for instance, a pulling of the wire after the intermediate annealing.

The exposure of the wire to an annealing step prior to using the wire in a bonding process may generally be understood as such intermediate annealing step or, alternatively, as a final annealing step. Such final annealing step is understood as a last step in wire production influencing the wire microstructure. Parameters of such final annealing steps are well known in the art.

In the case of exposing the wire to a final annealing step, an intermediate annealing has been performed before, meaning that at least two different annealing procedures in the production of the wire are performed. Operations with influence on the microstructure of the wire, like pulling steps, are performed between the intermediate annealing and the final annealing. This allows for a particular optimization of the crystal structure of a wire made by the manufacturing method of the invention.

The core precursor has a diameter of at least 0.5 mm when exposed to the intermediate annealing step. More preferred, the diameter is at least 1 mm. On the other hand, the diameter of the core during intermediate annealing does not exceed 10 mm, more preferred 5 mm. When forming bonding wires, in particular thin bonding wires, from such core precursors by pulling or other forming methods, the intermediate annealing prior to the forming steps significantly helps to obtain an advantageous crystal structure. A core precursor is defined as any pre-form of the final wire core, whilst the core precursor is processed by production steps like rolling, pulling, heating, or other.

The diameter reduction ratio obtained by forming steps, in particular pulling steps, between the final wire diameter and the intermediately annealed core is chosen in a range of 0.1 to 0.002, preferred from 0.05 to 0.005.

It is pointed out that a further optimization of the wire might comprise several intermediate annealing procedures, though for efficiency of production, just one intermediate annealing step is preferred.

The intermediate annealing step comprises an exposure of the wire to an annealing temperature in the range of 450 °C and 550 °C for an exposure time in the range of 30 minutes and 120 minutes prior to step b.

A cooling step is to be understood as a downward sloping temperature curve from the annealing temperature to a lower temperature. This lower temperature may be room temperature or any other temperature at which no more significant change in the structure of the wire occurs. In particular, the lower temperature may be a normal operational temperature of the wire, as such operational temperatures are chosen in a range where no significant influence on the crystal structure is expected. An example for a typical operational temperature e.g. for usual LED applications is in the range of 70 °C.

The form of a temperature vs. time diagram from the start to the end of the cooling step is preferably, but not necessarily, linear.

A specifically advantageous influence on the crystal structure is achieved if the duration of the cooling step is at least half of the duration of the exposure time of the intermediate annealing. Even more preferred, the duration of the cooling step is about the same as the duration of the intermediate annealing step. It surprisingly turned out that a rather slow and controlled cooling improves the homogenity of the crystal structure significantly.

The present invention is particularly related to the manufacture of thin bonding wires. The observed effects are specifically beneficial to thin wires, in particular concerning control of grain size and grain orientation. In the present case, the term "thin wire" is defined as a wire having a diameter in the range of 8 µm to 80 µm. Particularly preferred, a thin wire made by the manufacturing method according to the invention has a diameter of less than 30 µm. In such thin wires, the composition and annealing particularly helps to achieve beneficial properties.

Such thin wires have a cross-sectional view essentially in the shape of a circle. The term "a cross-sectional view" in the present context refers to a view of a cut through the wire, wherein the plane of the cut is perpendicular to the longitudinal extension of the wire. The cross-sectional view can be found at any position on the longitudinal extension of the wire. A "longest path" through the wire in a cross-section is the longest chord which can be laid through the cross-section of the wire within the plane of the cross-sectional view. A "shortest path" through the wire in a cross-section is the longest chord perpendicular to the longest path within the plane of the cross-sectional view defined above. If the wire has a perfect circular cross-section, then the longest path and the shortest path become indistinguishable and share the same value. The term "diameter" is the arithmetic mean of all geometric diameters of any plane and in any direction, wherein all planes are perpendicular to the longitudinal extension of the wire.

It has turned out that the wire made by the manufacturing method according to the invention is not only excellently suitable for bonding light emitting diode (LED) devices, but also the reflectivity of the wire material turned out to give good results with this particular application.

It is to be understood that the pulling of the precursor may be done in several steps. The wire core precursor is understood to have the composition of a wire made by the manufacturing method of the invention. Such precursor can be simply obtained by melting a defined amount of silver, adding the further components in the defined amounts and taking care of a homogenous mixture. The wire core precursor can then be cast or formed in any known manner from the molten or solidified alloy.

The manufacturing method of the invention comprises the step of:
d. intermediate annealing of the wire core precursor prior to step b.

This additional intermediate annealing step leads to an optimization of the crystal structure prior to the strong mechanical deformations as they occur in pulling the wire or the like. It turned out that the intermediate annealing is beneficial for the finally resulting microstructure of the wire. For instance, the intermediate annealing can help to reduce the deviation of grain size in the final product, improve the orientation of the grains and more. The parameters of the intermediate annealing can be adapted with respect to the required wire parameters.

The method further comprises the step of cooling the wire after intermediate annealing from at least the annealing temperature down to room temperature, wherein the duration of the cooling step is at least half of the duration of the exposure time of the intermediate annealing or the same as the duration of the intermediate annealing step.

Concerning more preferred detail embodiments of the method for manufacturing the wire, in particular with respect to optimized annealing parameters, reference is made to the above description of a wire.

### DESCRIPTION OF THE FIGURES

The subject matter of the invention is exemplified in the figures. The figures, however, are not intended to limit the scope of the invention or the claims in any way.
- Figure 1: shows a scan of a cross sectional preparation of a wire made by the manufacturing method of the invention, wherein crystal grain borders are visible.
- Figure 2: shows a diagram of a grain size evaluation of a wire made by the manufacturing method of the invention, compared with a wire missing an intermediate annealing.
- Figure 3: shows the wire from Fig. 1 with crystal grains of different orientation being marked and evaluated.
- Figure 4: shows a diagram with an evaluation of the grain sizes of the wire from Fig. 1.

### EXAMPLE

The invention is further exemplified by an example. This example serves for exemplary elucidation of the invention and is not intended to limit the scope of the invention or the claims in any way.

An alloy was been prepared by melting a predetermined amount of pure silver and adding predetermined amounts of pure gold and palladium in order to obtain a well-mixed composition as follows (in weight-%):

| Silver | Gold | Palladium |
|---|---|---|
| 89% | 8% | 3% |

The molten mixture was cast into a form and cooled in order to obtain a wire core precursor. The wire precursor had a diameter of 2 mm.

The 2 mm diameter wire core precursor was then annealed in an intermediate annealing step. In this step, the core precursor was inserted into an annealing oven preheated to a temperature of 500 °C. Then the core precursor remained in the oven at constant temperature of 500 °C for an exposure time of 90 minutes.

The intermediate annealing step was continuously followed by a cooling step with the following parameters: Decreasing the oven temperature linearly from 500 °C down to room temperature during a time period of 90 minutes.

The intermediately annealed core precursor was then pulled to a thin wire of 18 µm final diameter in several pulling steps.

The resulting 18 µm wire was then annealed in a final annealing step with usual annealing parameters.

The resulting wire was used for several tests.

First, the wire was compared with two standard wires based on silver alloys similar to the wire. The comparison measurements comprise data on the resistivity of the wires, on stitch pull behavior and on ball shearing behavior. For these properties of the wires, standard tests procedures in the field of wire bonding have been used.

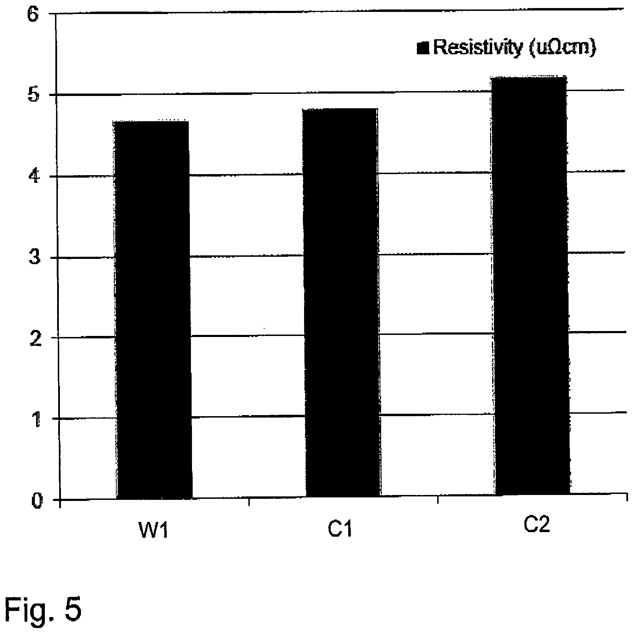

Fig. 5 shows a diagram comparing the three wires. The wire made by the manufacturing method according to the invention is named W1, and the two comparative wires are named C1 and C2. The resistivity of the wires has the following values:

**(Table 1)**

| | W1 | C1 | C2 |
|---|---|---|---|
| Resistivity [µΩ×cm]: | 4,66 | 4,80 | 5,10 |

The wire sample W1 has the lowest resistivity by far (less than 4.7 µΩ×cm), which generally is a very advantageous feature of a bonding wire.

Comparing the stitch pull behavior, not only high stitch pull values are advantageous, but even more low deviations of the values, as a low deviation provides for a high control and reliability in a manufacturing process.

The results for the three wires are given in table 2 below:

**(Table 2)**

| Stitch pull [grams] | W1 | C1 | C2 |
|---|---|---|---|
| Minimum | 2.0 | 2.2 | 2.0 |
| Maximum | 2.8 | 3.9 | 2.6 |
| Average | 2.4 | 2.9 | 2.2 |
| Stand. deviation σ | 0.2 | 0.5 | 0.2 |

The data shows that the wire made by the manufacturing method of the invention is advantageous with respect to the wire C1 as it has a significantly better deviation. For wire C2, the wire made by the manufacturing method of the invention is at least as advantageous because it has a higher average value with the same deviation.

Comparing the ball shear property, not only high pull values are advantageous, but even more low deviations of the values, as a low deviation provides for a high control and reliability in a manufacturing process. The results for the three wires are given in table 3 below:

**(Table 2)**

| Ball shear [grams] | W1 | C1 | C2 |
|---|---|---|---|
| Minimum | 11.1 | 10.6 | 10.6 |
| Maximum | 14.5 | 13.6 | 13.2 |
| Average | 12.6 | 12.0 | 12.0 |
| Stand. deviation σ | 0.2 | 0.5 | 0.2 |

The data on the ball shearing property shows that the wire made by the manufacturing method of the invention is advantageous over both comparison wires as it has the highest average value combined with the lowest deviation.

In the following, the wire made by the manufacturing method of the invention is described in detail with respect to its specific properties.

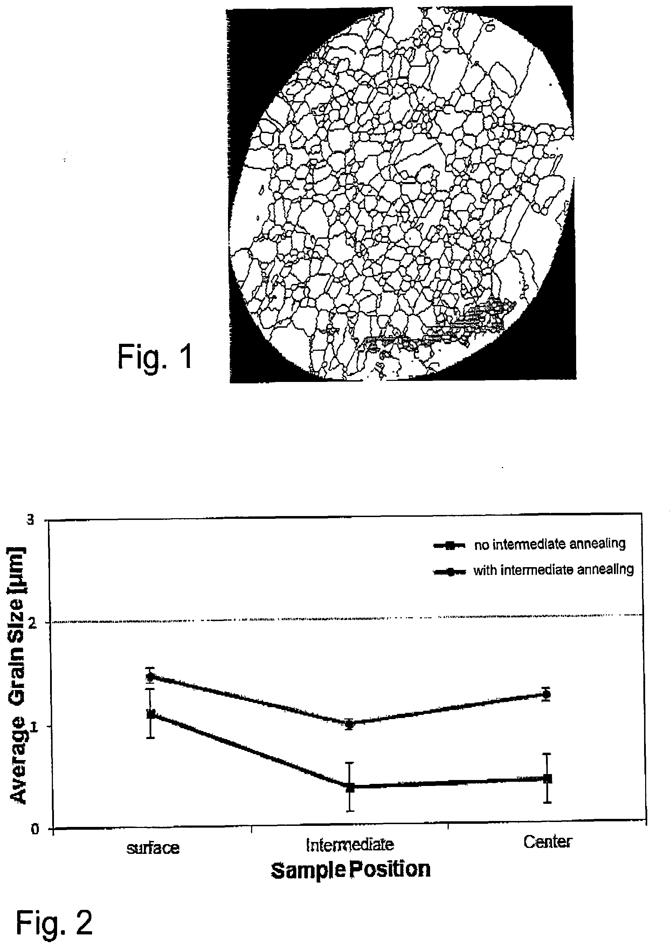

Fig. 1 shows a measurement of a sample preparation of the wire made by the manufacturing method of the invention. The sample preparation was done in several steps:
- A piece of the wire was coiled on a steel support with rectangular cross section.
- The coiled wire and steel support were embedded in a resin by molding.
- A cross section through the embedded the wire was cut.
- The cross sectional area of the wire was polished in several steps with a final polishing grain size of 0.04 µm.
- The polished surface was cleaned and then treated by ion milling.

Several measurements on the microtexture of the wire were made, in particular by means of Electron Backscattering Diffractometry (EBSD). The analysis tool used was a FE-SEM Hitachi S-4300E. The software package used for measurement and data evaluation is called TSL and is commercially available from Edax Inc., US (www.edax.com).

With these measurements, size and distribution of the crystal grains of the wire as well as the crystal orientation have been determined. As the measurement and evaluation of crystal grains is presently performed by EBSD measurement, it is to be understood that a tolerance angle of 5° was set for the determination of grain boundaries.

The image of fig. 1 shows a scan of a cross section of 18 µm diameter through the wire, wherein the crystal grains of the wire material are indicated by their grain boundaries. All of the single crystal grains have been evaluated with respect of their size and their crystal orientation.

In this evaluation, three different regions of the cross section have been defined for a better in-depth understanding. The regions are named "surface", "intermediate" and "center", dependent on a radial distance from the center of the essentially circular cross section. Each of the three regions has about the same share of the total cross sectional area.

In fig. 2, an average size of the crystal grains is displayed for each of the regions for the wire for a wire missing the intermediate annealing and cooling step (lower curve) and for a wire with intermediate annealing and cooling step having been performed as described above. (upper curve). The standard deviation of the size of the grains is displayed by perpendicular bars at the respective diagram point.

The total average grain size is about 1.2 µm for the intermediately annealed wire, with a standard deviation of less than 0.13 µm averaged over the different regions. For the different regions, no average grain size is below 1 µm and no standard deviation is greater than 0.15 µm.

An orientation was set with reference to the lengthwise direction of the wire samples and defined as <001> orientation.

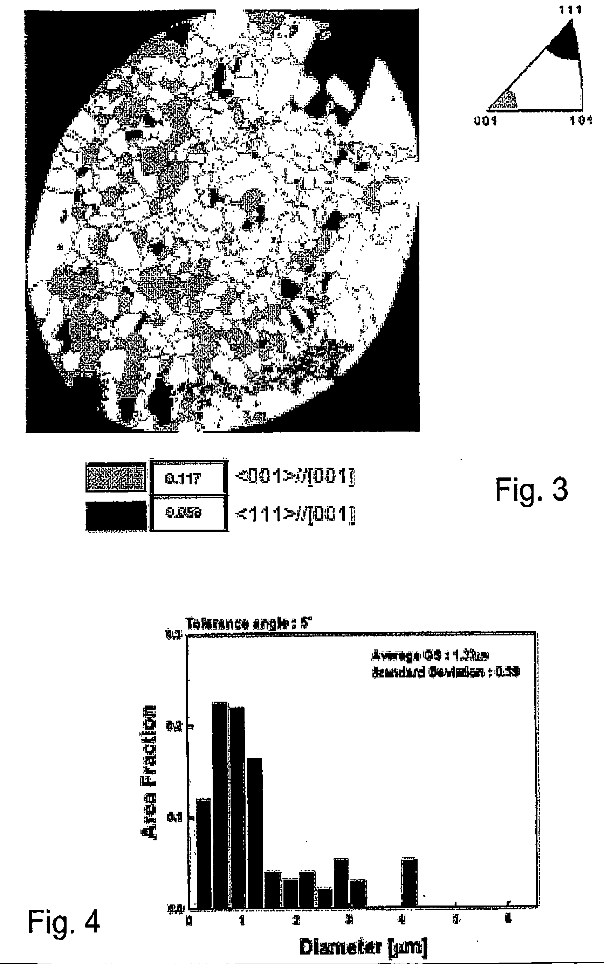

As displayed in fig. 3, the crystal grains of the wire of fig. 1 have been evaluated concerning their orientation with respect to the wire axis. In the top right corner of fig. 3, a triangle references the different orientations as a commonly used way of presentation. The three basic or main orientations <001 >, <101> and <111> belong to the respective corners of the triangle.

In the present evaluation, a crystal grain is defined to belong to the <001> orientation (or <111> orientation, respectively.), if its measured orientation is within a tolerance angle of 15° with respect to the <001 > orientation (or <111> orientation, respectively). In the triangle, these tolerance angles are visible for the case of the <001 > orientation and the <111> orientation as filled areas, with two different shades of grey for the two orientations. The respective grains of these orientations are marked in the same color of grey shade in the wire cross section. The other grains of white color do not belong to the <001 > or the <111 > orientation.

Evaluation of the counted grains shows that 11.7 % of the total number of grains belong to the <001> orientation and 6.9 % of the total number of grains belong to the <111> orientation.

A comparison with the comparative wires C1 and C2 shows:

| Number share of grains [%], tolerance 15° | W1 | C1 | C2 |
|---|---|---|---|
| <001> orientation | 11.7 | 8.2 | 27.0 |
| <111> orientation | 6.9 | 3.4 | 20.3 |
| sum of <001 > and <111 > orientation | 18.6 | 11.6 | 47.3 |

These results and further evaluation confirm that the wire samples made by the manufacturing method of the invention have a distribution of particles of specific orientations with the following properties:
a. The amount of crystal grains having an orientation in <001> direction in the cross section of the wire is in the range of 10 - 20 %.
b. The amount of crystal grains having an orientation in <111> direction in the cross section of the wire is in the range of 5 - 15 %.
c. The total amount of crystal grains having an orientation in <001> direction and of crystal grains having an orientation in <111> direction in the cross section of the wire is in the range of 15 - 40 %.
d. An average size of crystal grains of the core is between 0.8 µm and 3 µm.

It turned out that wires made by the manufacturing method of the invention having at least one of these properties show good properties in the bonding processes as described above. Further advantageously, any two or more of the features a-d are simultaneously present.

## Claims

1. A method for manufacturing a bonding wire having a diameter in the range of 8 to 80 µm and comprising a core with a surface, wherein the core comprises silver as a main component and at least one member selected from the group consisting of gold, palladium and platinum, **characterized in that** the bonding wire has at least one of the following combinations of properties:
i) an average size of crystal grains of the core is between 0.8 µm and 3 µm,
ii) the amount of crystal grains having an orientation in <001> direction in the cross section of the wire is in the range of 10 - 20 %, and
iii) the total amount of crystal grains having an orientation in <001 > direction and of crystal grains having an orientation in <111> direction in the cross section of the wire is in the range of 15 - 40 %,
or
i) an average size of crystal grains of the core is between 0.8 µm and 3 µm,
ii) the amount of crystal grains having an orientation in <111> direction in the cross section of the wire is in the range of 5 - 15 %, and
iii) the total amount of crystal grains having an orientation in <001 > direction and ofcrystal grains having an orientation in <111> direction in the cross section of the wire is in the range of 15 - 40 %,
or
i) an average size of crystal grains of the core is between 0.8 µm and 3 µm,
ii) the amount of crystal grains having an orientation in <001 > direction in the cross section of the wire is in the range of 10 - 20 %, and
iii) the amount of crystal grains having an orientation in <111> direction in the cross section of the wire is in the range of 5 - 15 %,
wherein the method comprises the steps of
a. providing a wire core precursor,
b. pulling the precursor until a final diameter of the wire core is reached,
c. annealing the pulled wire at a minimum annealing temperature for a minimum annealing time,
d. intermediate annealing of the wire core precursor at an intermediate annealing temperature in the range of 450 °C and 550 °C and for an intermediate annealing time in the range of 30 minutes and 120 minutes prior to step b, and
e. cooling the wire after intermediate annealing from at least the intermediate annealing temperature down to room temperature, wherein the duration of the cooling step is at least half of the duration of the exposure time of the intermediate annealing or the same as the duration of the intermediate annealing step, wherein the core precursor has a diameter of at least 0,5 mm when exposed to the intermediate annealing step,
wherein the diameter of the core during intermediate annealing does not exceed 10 mm, and
wherein the diameter reduction ratio obtained by forming steps between the final wire diameter and the intermediately annealed core is chosen in a range of 0.1 to 0.002.

2. The method of claim 1, wherein the diameter of the wire is in the range of 10 to 30 µm.

3. The method of claim 1 or 2, wherein the core comprises 80 - 95 wt.% silver, 5 - 12 wt.% gold, 1.5 - 5 wt.% palladium and up to 0.01 wt.% unavoidable impurities.

4. The method of claim 1 or 2, wherein the core comprises 90 - 99.7 wt.% silver, 0.3 - 10 wt.% gold and up to 0.01 wt.% unavoidable impurities.

5. The method of claims 1 or 2, wherein the core comprises 90 - 99.7 wt.% silver, 0.3 - 10 wt.% palladium and up to 0.01 wt.% unavoidable impurities.

6. The method of claim 1 or 2, wherein the core comprises 80 - 99 wit.% silver, 0 - 10 wt.% gold, 1 - 20 wit.% palladium and up to 0.01 wt.% unavoidable impurities.

7. The method of any one of the preceding claims, wherein the average size of crystal grains of the core is between 1.0 µm and 1.6 µm.

8. The method of any one of the preceding claims, wherein a standard deviation of the size of the crystal grains is between 0 µm and 0.5 µm or, preferably, between 0 µm and 0.4 µm.

9. A bonding wire made by a method of any one of the preceding claims.

## Patentansprüche

1. Verfahren zur Herstellung eines Bonddrahtes mit einem Durchmesser im Bereich von 8 bis 80 µm und umfassend einen Kern mit einer Oberfläche, wobei der Kern Silber als einen Hauptbestandteil und mindestens eines ausgewählt aus der Gruppe bestehend aus Gold, Palladium und Platin umfasst, **dadurch gekennzeichnet, dass** der Bonddraht mindestens eine der folgenden Kombinationen von Eigenschaften aufweist:
i) eine durchschnittliche Größe von Kristallkörnern des Kerns beträgt zwischen 0,8 µm und 3 µm,
ii) die Menge an Kristallkörnern mit einer Orientierung in <001> Richtung im Querschnitt des Drahtes liegt im Bereich von 10 - 20 %, und
iii) die Gesamtmenge an Kristallkörnern mit einer Orientierung in <001> Richtung und von Kristallkörnern mit einer Orientierung in <111> Richtung im Querschnitt des Drahtes liegt im Bereich von 15 - 40 %,
oder
i) eine durchschnittliche Größe von Kristallkörnern des Kerns beträgt zwischen 0,8 µm und 3 µm,
ii) die Menge an Kristallkörnern mit einer Orientierung in <111> Richtung im Querschnitt des Drahtes liegt im Bereich von 5 - 15 %, und
iii) die Gesamtmenge an Kristallkörnern mit einer Orientierung in <001> Richtung und von Kristallkörnern mit einer Orientierung in <111> Richtung im Querschnitt des Drahtes liegt im Bereich von 15 - 40 %,
oder
i) eine durchschnittliche Größe von Kristallkörnern des Kerns beträgt zwischen 0,8 µm und 3 µm,
ii) die Menge an Kristallkörnern mit einer Orientierung in <001> Richtung im Querschnitt des Drahtes liegt im Bereich von 10 - 20 %, und
iii) die Menge von Kristallkörnern mit einer Orientierung in <111> Richtung im Querschnitt des Drahtes liegt im Bereich von 5 - 15 %,
wobei das Verfahren die Schritte umfasst
a. Bereitstellen eines Drahtkernvorgängers, Ziehen des Vorgängers bis ein endgültiger Durchmesser des Drahtkerns erreicht ist,
b. Glühen des gezogenen Drahtes bei einer Mindest-Glühtemperatur für eine Mindest-Glühdauer,
c. Zwischenglühen des Drahtkernvorgängers bei einer Zwischenglühtemperatur im Bereich von 450 °C und 550 °C und für eine Zwischenglühdauer im Bereich von 30 Minuten und 120 Minuten vor Schritt b, und
d. Abkühlen des Drahtes nach dem Zwischenglühen von mindestens der Zwischenglühtemperatur bis auf Raumtemperatur, wobei die Dauer des Abkühlungsschritts mindestens der Hälfte der Expositionsdauer des Zwischenglühens oder der Dauer des Zwischenglühschritts entspricht, wobei der Drahtvorgänger einen Durchmesser von mindestens 0,5 mm besitzt, wenn er dem Zwischenglühschritt ausgesetzt wird,
wobei der Durchmesser des Kerns beim Zwischenglühen einen Wert von 10 mm nicht übersteigt, und
wobei das durch Umformschritte erhaltene Durchmesser-Reduktionsverhältnis zwischen dem endgültigen Drahtdurchmesser und dem zwischengeglühten Kern in einem Bereich von 0,1 bis 0,002 gewählt wird.

2. Verfahren nach Anspruch 1, wobei der Durchmesser des Drahtes im Bereich von 10-30 µm liegt.

3. Verfahren nach Anspruch 1 oder 2, wobei der Kern 80 - 95 Gew.-% Silber, 5 - 12 Gew.-% Gold, 1,5 - 5 Gew.-% Palladium und bis zu 0,01 Gew.-% unvermeidbare Verunreinigungen umfasst.

4. Verfahren nach Anspruch 1 oder 2, wobei der Kern 90 - 99,7 Gew.-% Silber, 0,3 - 10 Gew.-% Gold und bis zu 0,01 % unvermeidbare Verunreinigungen umfasst.

5. Verfahren nach Anspruch 1 oder 2, wobei der Kern 90 - 99,7 Gew.-% Silber, 0,3 - 10 Gew.-% Palladium und bis zu 0,01 % unvermeidbare Verunreinigungen umfasst.

6. Verfahren nach Anspruch 1 oder 2, wobei der Kern 80 - 99 Gew.-% Silber, 0 - 10 Gew.-% Gold, 1 - 20 Gew.-% Palladium und bis zu 0,01 % unvermeidbare Verunreinigungen umfasst.

7. Verfahren nach einem der vorhergehenden Ansprüche, wobei die durchschnittliche Größe von Kristallkörnern des Kerns zwischen 1,0 µm und 1,6 µm beträgt.

8. Verfahren nach einem der vorhergehenden Ansprüche, wobei eine Standardabweichung der Größe der Kristallkörner zwischen 0 µm und 0,5 µm oder, vorzugsweise, zwischen 0 µm und 0,4 µm beträgt.

9. Bonddraht hergestellt durch ein Verfahren nach einem der vorhergehenden Ansprüche.

## Revendications

1. Méthode de fabrication d'un fil de connexion dont le diamètre est compris entre 8 et 80 µm, qui comporte une âme avec une surface, où l'âme se compose principalement d'argent et d'au moins un membre sélectionné dans le groupe composé d'or, de palladium et de platine, **caractérisée par le fait que** le fil de connexion présente au moins l'une des combinaisons de propriétés suivantes :
i) la taille moyenne des grains cristallins de l'âme est comprise entre 0,8 µm et 3 µm,
ii) la proportion de grains cristallins orientés dans la direction <001> sur la coupe transversale du fil est comprise entre 10 et 20 %, et
iii) la proportion totale de grains cristallins orientés dans la direction <001 > et de grains cristallins orienté dans la direction <111> sur la coupe transversale du fil est comprise entre 15 et 40 %.
ou
i) la taille moyenne des grains cristallins de l'âme est comprise entre 0,8 µm et 3 µm,
ii) la proportion de grains cristallins orientés dans la direction <111> sur la coupe transversale du fil est comprise entre 5 et 15 %, et
iii) la proportion totale de grains cristallins orientés dans la direction <001 > et de grains cristallins orienté dans la direction <111> sur la coupe transversale du fil est comprise entre 15 et 40 %.
ou
i) la taille moyenne des grains cristallins de l'âme est comprise entre 0.8 µm et 3 µm,
ii) la proportion de grains cristallins orientés dans la direction <001> sur la coupe transversale du fil est comprise entre 10 et 20 %, et
iii) la proportion de grains cristallins orientés dans la direction <111> sur la coupe transversale du fil est comprise entre 5 et 15 %.
où la méthode comprend les étapes suivantes :
a. fournir un précurseur d'âme de fil,
b. tirer le précurseur jusqu'à atteindre le diamètre final de l'âme du fil,
c. recuire le file tiré à une température minimale de recuisson pendant une durée minimale de recuisson,
d. opérer une recuisson intermédiaire du précurseur d'âme de fil à une température intermédiaire de recuisson comprise entre 450 et 550 °C et pendant une durée intermédiaire de recuisson comprise entre 30 et 120 minutes avant de passer à l'étape b, et
e. refroidir le fil après la recuisson intermédiaire en le faisant au moins passer de la température intermédiaire de recuisson à la température ambiante, où la durée de l'étape de refroidissement est au moins moitié moins longue que la durée d'exposition de la recuisson intermédiaire ou aussi longue que la durée de l'étape de recuisson intermédiaire, où le précurseur d'âme présente un diamètre d'au moins 0,5 mm lorsqu'il est exposé à l'étape de recuisson intermédiaire,
où le diamètre de l'âme pendant la recuisson intermédiaire ne dépasse pas 10 mm, et
où le rapport de réduction obtenu par les étapes de formation entre le diamètre final du fil et l'âme soumise à une recuisson intermédiaire est compris entre 0,1 et 0,002.

2. Méthode selon la revendication 1, où le diamètre du fil est compris entre 10 et 30 µm.

3. Méthode selon la revendication 1 ou 2, où l'âme se compose à 80 - 95 % en poids d'argent, à 5 - 12 % en poids d'or, à 1,5 - 5 % en poids de palladium et jusqu'à 0,01 % en poids d'impuretés inévitables.

4. Méthode selon la revendication 1 ou 2, où l'âme se compose à 90 - 99,7 % en poids d'argent, à 0,3 - 10 % en poids d'or et jusqu'à 0,01 % en poids d'impuretés inévitables.

5. Méthode selon la revendication 1 ou 2, où l'âme se compose à 90 - 99,7 % en poids d'argent, à 0,3 - 10 % en poids de palladium et jusqu'à 0,01 % en poids d'impuretés inévitables.

6. Méthode selon la revendication 1 ou 2, où l'âme se compose à 80 - 99 % en poids d'argent, à 0 - 10 % en poids d'or, à 1 - 20 % en poids de palladium et jusqu'à 0,01 % en poids d'impuretés inévitables.

7. Méthode selon l'une des revendications précédentes, où la taille moyenne des grains cristallins de l'âme est comprise entre 1 µm et 1,6 µm.

8. Méthode selon l'une des revendications précédentes, où l'écart type de la taille des grains cristallins est compris entre 0 µm et 0,5 µm ou, de préférence, entre 0 µm et 0,4 µm.

9. Fil de connexion fabriqué au moyen d'une méthode selon l'une des revendications précédentes.
